# EUROPEAN PATENT APPLICATION

(11) **EP 2 015 461 A2**
(43) Date of publication of application: **14.01.2009**
(21) Application number: 08252329.1
(22) Date of filing: 08.07.2008
(51) Int. Cl.: H04B 1/10, H03G 3/34

(54) **Impulse Noise Detection and Mitigation in Receivers**

(30) Priority: 10.07.2007 US 775836
(71) Applicant: Advanced Micro Devices, INC., Sunnyvale CA 94085 (US)
(72) Inventor: Rajagopal, Ravikiran, Yardley 19067 Pennsylvania (US)
(74) Representative: Reeve, Anna Elizabeth

(57) **Abstract**

Methods and apparatus, including computer program products, are provided for detecting and mitigating noise, such as impulse noise. In one aspect, there is provided a noise suppressor to determine a predicted value for a sample in a bit stream, the predicted value determined without regard to an average of the bit stream. The noise suppressor may also detect whether impulse noise is present based on a difference between the predicted value and the sample. The noise suppressor may also identify the sample as impulse noise to enable the sample to be replaced with another value.

## Description

### FIELD

The present disclosure generally relates to noise detection and mitigation.

### BACKGROUND

Noise refers to any unwanted aspects of a signal. For example, when a signal is transmitted and then recovered at a receiver, the originally transmitted signal may include unwanted signals, such as interference, thermal noise, impulse noise, as well as other types of interference, which may be considered noise as well. Impulse noise is a type of noise characterized by a transient, a spike, or a burst. Impulse noise may be caused by electrical sources, such as lightning, electric motors, power switches, domestic lights, thermostats, gas lighters, car ignition systems, and anything that creates an abrupt change of current in a conductor.

An antenna of a high definition television receiver may receive a high definition signal broadcast over-the-air. The received signal may include impulse noise caused by lightning, motors (e.g., a vacuum cleaner), and the like. The impulse noise corrupts the received signal introducing errors - resulting thus in errors in the decoded signal. From the perspective of a user of a high definition television receiver, these errors caused by impulse noise may result in degraded picture and sound quality. More worrisome, the user may, because of the degraded picture quality, regret purchasing the high definition television receiver. Therefore, there is a continuing need to improve the quality of the received signal by mitigating impulse noise.

### SUMMARY

The subject matter disclosed herein provides methods and apparatus, including computer program products, for detecting and mitigating noise including impulse noise.

Methods and apparatus, including computer program products, are provided for detecting noise, such as impulse noise. In one aspect, there is provided a noise suppressor to determine a predicted value for a sample in a bit stream, the predicted value determined without regard to an average of the bit stream. The noise suppressor may also detect whether impulse noise is present based on a difference between the predicted value and the sample. The noise suppressor may also identify the sample as impulse noise to enable the sample to be replaced with another value.

Variations may include one or more of the following features. The predicted value may be determined using a spline interpolation. The spline interpolation may use a first path for one or more even samples in the bit stream and a second path for one or more odd samples in the bit stream. The first and second paths may be recombined after a determination is made regarding whether impulse noise is present in the bit stream. The first path may process the one or more even samples in the bit steam by down sampling and interpolating the bit steam and determine the difference using the predicted sample obtained from the first path and the sample obtained from the second path. The detection of whether impulse noise is present may be based on whether the difference between the predicted sample and the sample exceeds a threshold. A threshold of 0.1 of the difference may be used. The other value may be determined as the predicted value, so that the sample may be replaced (e.g., inserted) with the determined value.

The subject matter described herein may be implemented to realize the advantages of reducing and mitigating impulse noise associated with receivers, such as televisions, radios, and the like.

It is to be understood that both the foregoing general description and the following detailed description are exemplary and explanatory only and are not restrictive. Further features and/or variations may be provided in addition to those set forth herein. For example, the implementations described herein may be directed to various combinations and subcombinations of the disclosed features and/or combinations and subcombinations of several further features disclosed below in the detailed description.

### BRIEF DESCRIPTION OF THE DRAWINGS

In the drawings,

FIG. 1 depicts a block diagram of an impulse noise detection and suppression system 100;

FIG. 2 depicts a process 200 for detecting and suppressing impulse noise;

FIG. 3a-b depict plots of predicted sample values and actual sample values; and

FIG. 4 depicts an implementation of an impulse noise suppression module 120.

Like labels are used to refer to same or similar items in the drawings.

### DETAILED DESCRIPTION

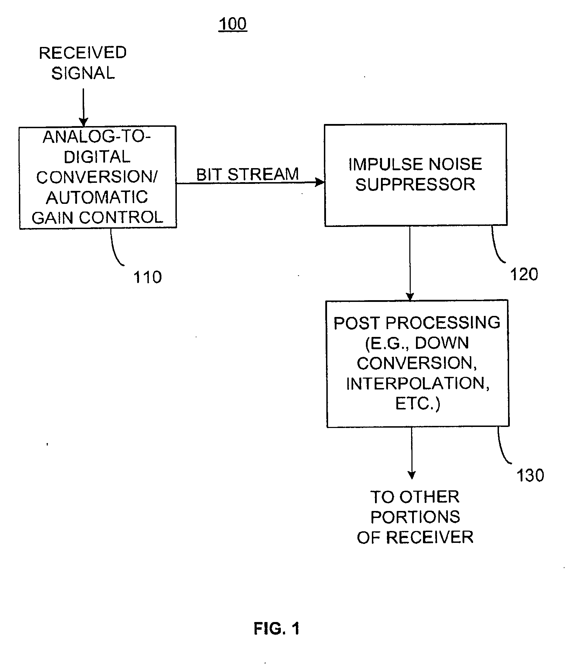

FIG. 1 depicts a block diagram of an impulse noise detection and suppression system 100. Impulse noise detection and suppression system 100 may be incorporated into any type of receiver, such as the radio frequency (RF) front-end of a high definition digital television receiver, to detect and mitigate (i.e., suppress) impulse noise. Impulse noise detection and suppression system 100 includes an analog-to-digital converter/automatic gain control module 110, an impulse noise suppression module 120, and a post-processing module 130. The term "module" refers to a portion of impulse noise detection and suppression system 100. Moreover, impulse noise detection and suppression system 100 including modules 110-130 may be implemented as hardware (e.g., an integrated circuit, Application Specific Integrated Circuit (ASIC), printed circuit board, etc.), software, firmware, and/or a combination of one or more of hardware, software, and firmware.

Analog-to-digital converter/automatic gain control module 110 may receive a signal, such as a radio frequency (RF) signal from an antenna or an intermediate frequency (IF) signal down converted (or tuned) from an antenna. An analog-to-digital converter included within module 110 may convert the received signal to a bit stream (also referred to as a "digital data stream," "digital data," or, simply, a "signal").

Analog-to-digital converter/automatic gain control module 110 may also include an automatic gain control feature for controlling the magnitude of the bit stream by providing gain. Automatic gain control controls the gain of an amplifier, so that the magnitude (e.g., voltage level) of the bit stream output by analog-to-digital converter/automatic gain control module 110 signal remains relatively stable for varying levels of input receive signal. The output of analog-to-digital converter/automatic gain control module 110 is a bit stream, such as a sequence of ones and zeroes (e.g., 10110), a time varying data signal having varying voltage levels, and the like.

The output of analog-to-digital converter/automatic gain control module 110 may include impulse noise. For example, if the electric motor of a vacuum cleaner is near a high definition digital television receiver, the output of analog-to-digital converter/automatic gain control module 110 may include impulse noise. Impulse noise degrades the quality of the bit stream. Therefore, when the bit stream including impulse noise is decoded into audio and video, the decoded audio and video information includes noise - affecting the quality of the decoded audio and video information.

Impulse noise suppressor 120 receives the bit stream and processes the bit stream to detect impulse noise and then suppress (i.e., mitigate), in whole or in part, the impulse noise when that noise is present in the bit stream.

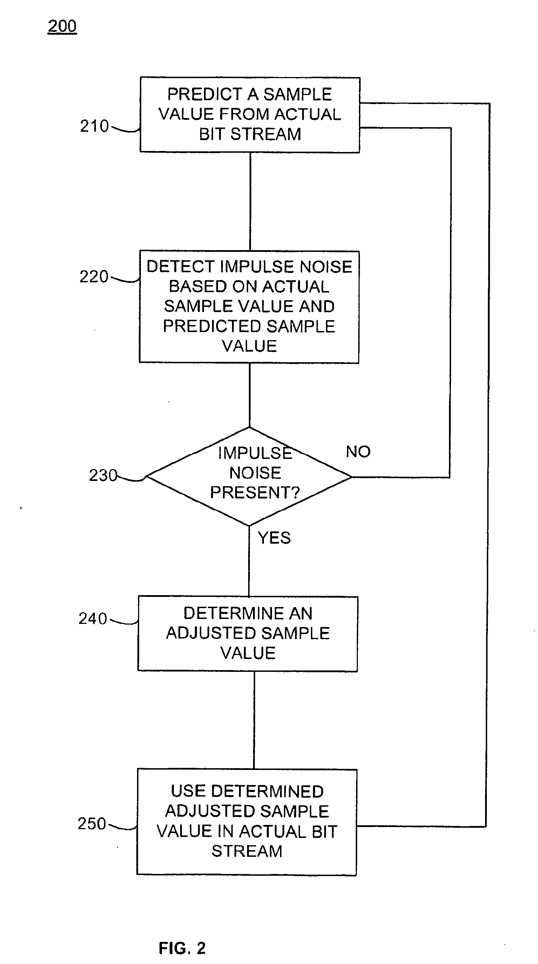

In one implementation, impulse noise suppressor 120 performs the process 200 depicted at FIG. 2 to detect and mitigate noise.

At 210, impulse noise suppressor 120 receives a bit stream and predicts a sample value from the received bit stream (referred to as the "actual sample values"). To predict a sample value (referred to as a "predicted sample value") from the actual sample value, impulse noise suppressor 120 may use one or more of the following approaches: a bandpass filter may be used in the case of intermediate frequency (IF) signals (e.g., usually input to analog-to-digital converter); a lowpass filter may be used for baseband input (e.g., from silicon tuners); and analog characteristics of the signal may be use as well.

To use a low pass filter to determine the predicted sample value, the low pass filter averages one or more of values from actual sample values to provide a predicted sample value. Although a low pass filter may be used as a predictor, another approach, an interpolator, such as a spline interpolator, may offer enhanced results when compared to using a low pass filter alone.

Interpolation generally refers to constructing predicted sample values from one or more actual sample values. There are a variety of ways of performing an interpolation, such as a linear interpolation (e.g., using linear functions), a spline interpolation, a rational interpolation (e.g., using interpolation by rational functions), a trigonometric interpolation (e.g., using interpolation by trigonometric polynomials, such as a discrete Fourier transform or a wavelet), a Whittaker-Shannon interpolation, and a multivariate interpolation (e.g., bilinear, bicubic, and trilinear) amongst others.

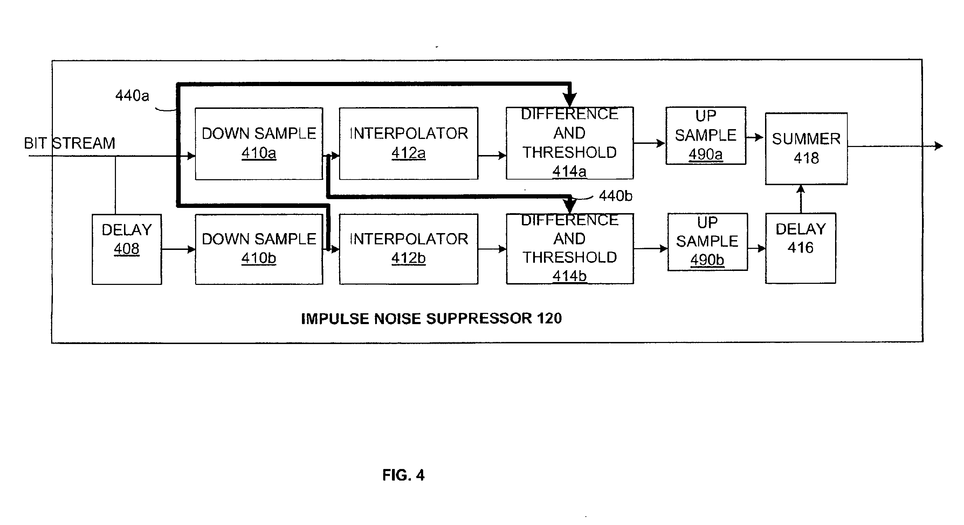

Spline interpolation uses low-degree polynomials as the interpolant rather than the linear function used with linear interpolation. In one implementation, a spline interpolation is used as described further below with respect to FIG. 4. Moreover, the use of a spline interpolation may offer enhanced results (e.g., improved detection of impulse noise), when compared to using only a low pass filter to determine predicted sample values.

Regardless of which interpolation approach is used, impulse noise suppressor 120 uses one or more actual sample values to determine a predicted sample value.

At 220, impulse noise suppressor 120 detects whether impulse noise is present in the bit stream based on the predicted sample value and the actual sample value. To detect whether impulse noise is present, impulse noise suppressor 120 may determine a difference between the predicted sample value and the actual sample value. When the difference exceeds a threshold, the actual sample value is likely to be impulse noise. The threshold may be implemented in a variety of ways including as a predetermined threshold value determined heuristically, a threshold value set as 1/10 the value of the overall range of actual sample values, and a threshold value set at 1 standard deviation from the mean power.

At 230, if the difference does not exceed a threshold, the actual sample value is not likely to be impulse noise, so impulse noise suppressor 120 may resume processing at 210 of FIG. 2.

At 230-240, if the difference does exceed a threshold, the actual sample value is likely to be impulse noise. When this is the case, impulse noise suppressor 120 determines an adjusted sample value. The adjusted sample value is another value used to replace (e.g., adjust, insert, etc.) the actual sample value in the bit stream considered likely to be impulse noise. For example, impulse noise suppressor 120 may determine that an actual sample value is likely to be impulse noise. Impulse noise suppressor 120 may then determine an adjusted sample value. The adjusted sample value may be determined using one or more of the following: a predicted sample value determined at 210, an average of one or more actual sample values, and a predetermined value.

At 250, the determined adjusted sample value is then used instead of the actual sample value. For example, at 250, impulse noise suppressor 120 may replace the actual sample value with the adjusted sample value.

Impulse noise suppressor 120 may repeat process 200 for one or more values in the bit stream received by impulse noise suppressor 120. The output bit stream of impulse noise suppressor 120 may, as a consequence of process 200, have fewer values corrupted by impulse noise, when compared to other approaches.

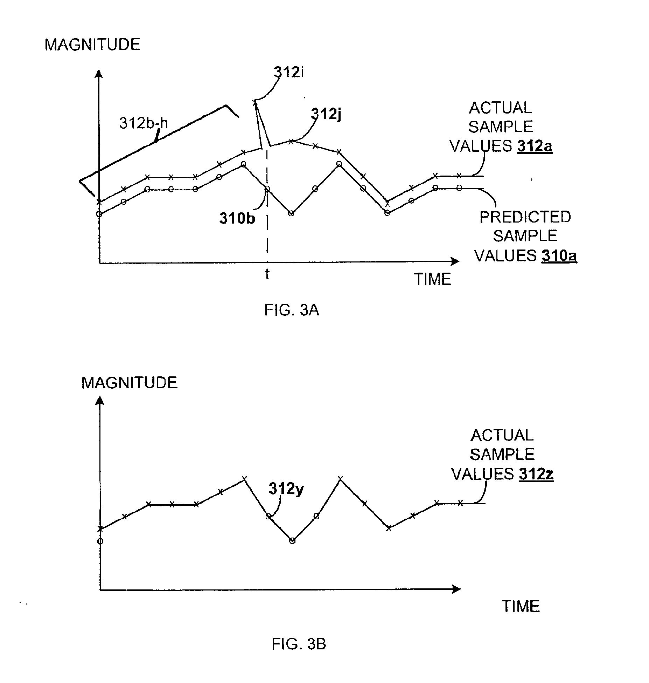

FIG. 3A depicts a plot of the bit stream 312a received at impulse noise suppressor 120. The bit stream 310a may be in the form of voltage values, binary coded information, or any other form. The bit stream 312a includes one or more actual sample values, such as values 312a-j. FIG. 3A also includes a set of predicted sample values 310a.

Referring to FIGs. 2 and 3A, at 210, impulse noise suppressor 120 determines a predicted sample value 310b using bit stream 312a. For example, at time t, impulse noise suppressor 120 predicts sample value 310b corresponding to actual sample value 312i. To make that prediction, impulse noise suppressor 120 may use a spline interpolation based on one or more of the actual sample values in bit stream 312a.

At 220, impulse noise suppressor 120 detects whether actual sample value 312i is impulse noise by comparing the difference between actual sample value 312i and predicted sample value 310b determined based on spline interpolation. If the difference exceeds a threshold, impulse noise suppressor 120 determines that actual sample value 312i is impulse noise.

At 230 -240, if impulse noise suppressor 120 determines that the difference exceeds a threshold, impulse noise suppressor 120 determines an adjusted value for actual sample 312i. In the case of the example of FIG. 3a, the difference may exceed the threshold, so impulse noise suppressor 120 determines an adjusted value to use instead of sample 312i, which is likely to be impulse noise.

At 250, impulse noise suppressor 120 may use the predicted sample value 310b as the adjusted value and replace 312i with the predicted sample value of 310b.

FIG. 3B depicts the bit stream 312z output by impulse noise suppressor 120. The bit stream 312z represents bit stream 312a after impulse noise suppressor 120 uses process 200 on the sample values in the bit stream 312a. Sample value 312y is the value that replaced sample 312i in the bit stream. Impulse noise suppressor 120 may repeat process 200 for actual sample 312j as well as other values in bit stream 312a to mitigate impulse noise in bit stream 312a.

Returning to FIG. 1, the output of impulse noise suppressor 120 is then provided to a post-processing module 130 for additional processing. In some implementations, post processing module 130 may include a rate converter (also referred to as a timing block) to convert the bit stream output by impulse noise suppressor 120 to another format. For example, the bit stream output by impulse noise suppressor 120 may be converted from an over sampled bit stream (i.e., in terms of the Nyquist rate) to an under sampled bit steam (i.e., lower than the Nyquist rate) before being provided to other components of the receiver.

FIG. 4 depicts an example implementation of impulse noise suppressor 120. Specifically, FIG. 4 depicts impulse noise suppressor 120 implemented using spline interpolation, although other forms of prediction may be used as well. The bit stream received by impulse noise suppressor 120 is split into two paths. The first path includes a down sample module 410a, an interpolator 412a, an upsampler 490a, and a difference and threshold module 414a. The second path includes a delay module 408, a down sample module 410b, an interpolator 412b, an upsampler 490b, and a difference and threshold module 414b. A feature of impulse noise suppression module 120 is the use of two paths, so that the first path can process some of the samples in the bit stream (e.g., even samples), while the second path can process the other samples in the bit stream (e.g., odd samples). After a determination is made regarding the presence of impulse noise (e.g., after difference and threshold modules 414a and b), the delay module 416 and summer 418 combine the first and second paths and provide them as an output of impulse noise suppressor 120. In some implementations, the upsamplers 490a and b are used to upsample to an appropriate rate the output of difference and threshold modules 419a and b.

The first path is down sampled (e.g., every other sample value is discarded or ignored) by down sample module 410a. Interpolator module 412a uses splines to interpolate the down sampled bit stream provided by down sample module 410a. The difference and threshold module 414a then determines the difference between the output of interpolator 412a and output of down sample module 410b. The output of interpolator 412a represents a predicted sample value, while the output 440a of down sample module 410b represents an actual sample value, although delayed by delay module 408. If difference and threshold module 414a determines that the difference exceeds a threshold, difference and threshold module 414a replaces the actual sample value in the bit stream with an adjusted value (e.g., a predetermined value, the predicted sample value, and the like).

Meanwhile, the second path is down sampled (e.g., every other sample value is discarded or ignored) by down sample module 410b. Interpolator module 412b uses splines to interpolate the down sampled bit stream provided by down sample module 410b. The difference and threshold module 414b then determines the difference between the output of interpolator 412b and output of down sample module 410a. The output of interpolator 412b represents a predicted sample value, while the output 440b of down sample module 410a represents an actual sample value. If difference and threshold module 414b determines that the difference exceeds a threshold, difference and threshold module 414b replaces the actual sample value in the bit stream with an adjusted value (e.g., a predetermined value, the predicted sample value, and the like).

The interpolators 412a and 412b may be implemented using a simple filter-based spline interpolation technique with very low filter orders that can be realized in hardware, although software and firmware implementations may be used as well. Simple algorithms for filter-based spline interpolations are described in "B-Spline Signal Processing: Part I - Theory," M. Unser et al., IEEE Trans. Signal Processing, vol. 41, pp. 821-833, Feb. 1993, and "B-Spline Signal Processing: Part 2 - Design and Applications," M. Unser et al., IEEE Trans. Signal Processing, vol. 41, pp. 834 -848, Feb. 1993, the contents of both of which are hereby incorporate herein by reference. Moreover, the spline interpolation filter coefficients may be programmable, so that signals with different characteristics (such as VSB, QAM, and OFDM) may be processed with the same hardware.

In some implementations, impulse noise suppressor 120 is associated with (e.g., includes) an application programming interface (API), which can be called by a device, such as a user interface, computer, and the like. For example, the device may call (by sending a message or other form of indication) the API of impulse noise suppressor 120 to initiate detection and mitigation of impulse noise by impulse noise suppressor 120 and to disable detection and mitigation of impulse noise by impulse noise suppressor 120.

As noted, the subject matter disclosed herein may be implemented to detect and mitigate noise including impulse noise. The subject matter disclosed herein may also be with a data stream that has been over sampled, with respect to the Nyquist rate, although the subject matter described herein may also be used in non-over sampled bit streams as well. When a signal is over sampled with an analog-to-digital converter at a rate higher than the Nyquist rate, there may be correlation between neighboring samples in the bit steam. This correlation may be used to detect the presence of impulse noise by, as described above, predicting a sample value from adjacent sample values by applying a smoothness constraint (e.g., spline interpolation); detecting impulse noise by comparing the difference between the actual sample value and the predicted sample value; and then applying a threshold.

Moreover, although the above describes using impulse noise suppressor 120 in the context of a receiver (and, more particularly, in the context of a high definition television receiver), the implementations described above may be used in any environment including, for example, a radio, a digital satellite radio, a mobile wireless device (e.g., a mobile phone), wireless-enabled personal digital assistants (e.g., Blackberries), home media players (e.g., Slingbox), GPS receivers, digital ship-to-shore communication links, and the like. Furthermore, although the above implementations are described within the context of impulse noise, the implementations described herein may also be used to detect and/or mitigate, in whole or in part, other forms of noise as well. In addition, to simplify the explanation of the features of the subject matter described herein, FIGs. 1-4 have been simplified to include only some of the aspects that may be included in system 100, impulse noise suppressor 120, or process 200. For example, there may be an additional automatic gain control module after the impulse noise suppressor module 120.

The systems and methods disclosed herein may be implemented as a computer program product, i.e., a computer program tangibly embodied in an information carrier, e.g., in a machine readable storage device or in a propagated signal, for execution by, or to control the operation of, data processing apparatus, e.g., a programmable processor, a computer, or multiple computers. A computer program can be written in any form of programming language, including compiled or interpreted languages, and it can be deployed in any form, including as a stand-alone program or as a module, component, subroutine, or other unit suitable for use in a computing environment.

The foregoing description is intended to illustrate but not to limit the scope of the invention, which is defined by the scope of the appended claims. Other embodiments are within the scope of the following claims.

## Claims

1. A method for mitigating noise comprising:
detecting whether impulse noise is present based on a difference between a predicted value for a sample in a bit stream and the sample, the predicted value determined without regard to an average of the bit stream; and
identifying the sample as impulse noise to enable the sample to be replaced with another value.

2. The method of claim 1, wherein determining a predicted value comprises:
using a spline interpolation to determine the predicted value without regard to the average of the bit stream.

3. The method of claim 2 further comprising:
determining the spline interpolation using a first path for one or more even samples in the bit stream and a second path for one or more odd samples in the bit stream, the first and second paths recombined after a determination is made regarding whether impulse noise is present in the bit stream.

4. The method of claim 3, wherein the first path further comprises:
processing the one or more even samples in the bit steam by down sampling and interpolating the bit steam; and
determining the difference using the predicted value obtained from the first path and the sample obtained from the second path.

5. The method of claim 1, wherein detecting further comprises further comprises:
detecting whether impulse noise is present based on whether the difference between the predicted value and the sample exceeds a threshold.

6. The method of claim 5 further comprising:
determining the threshold as 0.1 the difference.

7. The method of claim 1 further comprising:
determining the other value as the predicted value; and
replacing the sample with the other value by inserting the other value in the bit stream.

8. The method of claim 1, wherein identifying further comprises:
identifying the sample as impulse noise to enable the sample to be replaced with the other value by detecting whether impulse noise is present based on the difference exceeding a threshold value.

9. A system for mitigating noise in a bit stream of data comprising:
a noise suppressor module for determining a predicted value for a sample in a bit stream, the predicted value determined without regard to an average of the bit stream; detecting whether impulse noise is present based on a difference between the predicted value and the sample; and identifying the sample as impulse noise to enable the sample to be replaced with another value.

10. The system of claim 9, wherein the noise suppressor module further comprises:
a spline interpolator for determining the predicted value.

11. The system of claim 9 further comprising:
a spline interpolator including a first path for one or more even samples in the bit stream and a second path for one or more odd samples in the bit stream, the first and second paths recombined after a determination is made regarding whether impulse noise is present in the bit stream.

12. The system of claim 11, wherein the spline interpolator further comprises:
a difference and threshold module for determining the difference using the predicted value obtained from the first path and the sample obtained from the second path and for detecting whether impulse noise is present based on whether the difference between the predicted value and the sample exceeds a threshold.

13. A computer-readable medium containing instructions to configure a processor to perform a method, the method comprising:
determining a predicted value for a sample in a bit stream, the predicted value determined without regard to an average of the bit stream;
detecting whether impulse noise is present based on a difference between the predicted value and the sample; and
identifying the sample as impulse noise to enable the sample to be replaced with another value.

14. The computer-readable medium of claim 13, wherein determining a predicted value further comprises:
using a spline interpolation to determine the predicted value without regard to the average of the bit stream.

15. The computer-readable medium of claim 14 further comprising:
determining the spline interpolation using a first path for one or more even samples in the bit stream and a second path for one or more odd samples in the bit stream, the first and second paths recombined after a determination is made regarding whether impulse noise is present in the bit stream.

16. The computer-readable medium of claim 15, wherein the first path further comprises:
processing the one or more even samples in the bit steam by down sampling and interpolating the bit steam; and
determining the difference using the predicted value obtained from the first path and the sample obtained from the second path.

17. A method comprising:
making a call to an application programming interface, the call initiating a noise suppressor to perform at least one of detection and mitigation of noise by determining a predicted value for a sample in a bit stream, the predicted value determined without regard to an average of the bit stream; detecting whether impulse noise is present based on a
difference between the predicted value and the sample; and identifying the sample as impulse noise to enable the sample to be replaced with an adjusted sample.

18. The method of claim 17 further comprising:
making another call to the application programming interface to disable the noise suppressor.

19. A device comprising:
a component for making a call to an application programming interface, the call initiating a noise suppressor to perform at least one of detection and mitigation of noise by determining a predicted value for a sample in a bit stream, the predicted value determined without regard to an average of the bit stream; detecting whether impulse noise is present based on a difference between the predicted value and the sample; and identifying the sample as impulse noise to enable the sample to be replaced with an adjusted sample.

20. The device of claim 19, wherein the component further comprises.
a user interface for making the call.
